# EUROPEAN PATENT SPECIFICATION

(11) **EP 2 045 357 B1**
(45) Date of publication and mention of the grant of the patent: **29.07.2015**
(21) Application number: 08016877.6
(22) Date of filing: 25.09.2008
(51) Int. Cl.: C23C 16/34, C23C 16/507

(54) **Method of forming silicon nitride films**
Verfahren zur Herstellung von Siliziumnitridfilmen
Procédé de formation de films de nitrure de silicium

(30) Priority: 28.09.2007 JP 2007255925
(43) Date of publication of application: 08.04.2009
(73) Proprietor: FUJIFILM Corporation, Minato-ku Tokyo (JP)
(72) Inventor: Takahashi, Toshiya, Odawara-shi Kanagawa (JP)
(74) Representative: Hoffmann Eitle

(56) References cited:
- DE-A1- 19 943 741
- KASAMA Y ET AL: "IMPROVEMENT OF PECVD-SINX FOR TFT GATE INSULATOR BY CONTROLLING IONBOMBARDMENT ENERGY" IEICE TRANSACTIONS ON ELECTRONICS, ELECTRONICS SOCIETY, TOKYO, JP, vol. E79-C, no. 3, 1 March 1996 (1996-03-01), pages 398-406, XP000594515 ISSN: 0916-8524

## Description

The entire contents of a document cited in this specification are incorporated herein by reference.

### BACKGROUND OF THE INVENTION

The present invention relates to the technical field of forming silicon nitride films by plasma-enhanced chemical vapor deposition (CVD). The invention more specifically relates to a silicon nitride film-forming method capable of film formation at a high film deposition rate through inductively coupled plasma-enhanced chemical vapor deposition.

Silicon nitride films are employed as water vapor barrier films in various devices and optical elements requiring moisture resistance, and protective films (passivation films) and insulating films in semiconductor devices.

Plasma-enhanced CVD is used in methods of forming silicon nitride films.

A known technique of film formation by plasma-enhanced CVD is capacitively coupled plasma-enhanced chemical vapor deposition (hereinafter abbreviated as "CCP-CVD"), which is a technique involving applying a radio frequency voltage to two opposing electrodes to generate plasma between the electrodes, thus forming a film.

CCP-CVD has the following advantages: The structure is simple; and a gas material is supplied from the electrodes, which enables gas to be uniformly supplied to the whole film-forming area even in the case where the electrodes have an increased surface area (the gas is easily made uniform).

On the other hand, CCP-CVD suffers from a plasma electron density of as low as about 1 × 10⁸ to about 1 × 10¹⁰ electrons/cm³ and has difficulties in improving the film deposition rate. In addition, because the electrodes are present in the plasma-generating region, film deposition continued for an extended period of time causes adhesion and deposition of a film to the electrodes as well, which may hinder proper film deposition.

Under the circumstances, in equipment where film deposition is continuously carried out as an elongated polymer film or other material is transported in a longitudinal direction with a view to, for example, producing water vapor barrier films in large quantities, the polymer film serving as a substrate cannot travel at an improved speed, which may often not ensure high productivity. Film deposition to the electrodes also limits the length of the polymer film serving as a substrate.

What is more, CCP-CVD requires a high pressure of usually about several tens of Pa to about several hundred Pa to maintain plasma, and in cases where film deposition is continuously carried out in a plurality of film deposition spaces (film deposition chambers) connected to each other, has a deteriorated film quality due to undesired incorporation of a gas in any of the film deposition chambers.

In addition to the above-described CCP-CVD, plasma-enhanced CVD also includes a known technique called inductively coupled plasma-enhanced chemical vapor deposition (hereinafter abbreviated as "ICP-CVD").

ICP-CVD is a technique which involves supplying radio frequency power to an (induction) coil to form an induced magnetic field and an induced electric field, and generating plasma based on the induced electric field to form a film on a substrate.

ICP-CVD is a technique in which radio frequency power is supplied to a coil to form an induced electric field to thereby generate plasma and therefore requires no counter electrode which is essential in plasma formation by means of CCP-CVD. Plasma having a density of as high as at least 1 × 10¹¹ electrons/cm³ can also be easily generated. In addition, plasma can be generated at a lower pressure and a lower temperature compared with plasma formation by means of CCP-CVD.

Upon manufacture of semiconductor devices, silicon nitride films are formed by ICP-CVD.

For example, JP 2005-79254 A describes that a silicon nitride film has been conventionally formed through ICP-CVD by using a gas material including silane gas and ammonia gas and adjusting the substrate temperature and the radio frequency power to 350°C or higher and 6W/sccm or more, respectively.

JP 2005-79254 A proposes a silicon nitride film-forming method which aimed at preventing a decline in film quality due to an increased hydrogen content in the film as having been seen in the above-mentioned conventional silicon nitride film-forming method and according to which a silicon nitride film is formed through ICP-CVD at a substrate temperature of 50 to 300°C by supplying a gas material including silane gas and nitrogen gas in such a manner that the flow rate (supply flow rate) of the nitrogen gas is at least ten times that of the silane gas and by applying a radio frequency power of at least 3 W/sccm with respect to the total gas flow rate.

It is also described that, in this silicon nitride film-forming method, an inert gas serving as an excitation gas is supplied at a flow rate corresponding to up to 20% of the total flow rate of the silane gas and the nitrogen gas to improve the film deposition rate.

DE19943741 Al discloses a method according to which a silicon nitride film is formed through ICP-CVD by applying a gas material including silane gas, ammonia gas and nitrogen gas in such a manner that the flow rate of the nitrogen gas is 6.8 times the total flow rate of the silane gas and the ammonia gas.

### SUMMARY OF THE INVENTION

The above-mentioned method of forming (depositing) a silicon nitride film is capable of film deposition at a relatively low temperature while reducing the hydrogen content in the film. However, because the nitrogen gas used as the gas material has a low activity, this silicon nitride film-forming method is low in film deposition rate.

A high enough film deposition rate is not achieved even by using highly reactive ammonia gas as the gas material.

Therefore, as described above, equipment where film deposition is continuously carried out as an elongated substrate such as a polymer film is transported in a longitudinal direction requires slowing down the travel speed of the substrate, which hampers efficient production.

The present invention has been made to solve the aforementioned conventional problems and it is an object of the present invention to provide a silicon nitride film-forming method which is capable of forming a silicon nitride film through ICP-CVD at a high film deposition rate.

In order to achieve the above object, the present invention provides a silicon nitride film-forming method comprising the steps of: supplying a gas material including silane gas, ammonia gas and nitrogen gas in such a manner that a flow rate of the nitrogen gas is 1 to 5 times a total flow rate of the silane gas and the ammonia gas; and carrying out inductively coupled plasma-enhanced chemical vapor deposition to form a silicon nitride film.

The silicon nitride film is preferably formed at a substrate temperature of 0 to 150°C. The silicon nitride film is preferably formed on an organic material. The silicon nitride film is preferably formed on a substrate having a base material made of a polymer film.

According to the present invention having the features described above, a silicon nitride film is formed through ICP-CVD by using a gas material including silane gas, ammonia gas and nitrogen gas in such a manner that the flow rate of the nitrogen gas is 1 to 5 times the total flow rate of the silane gas and the ammonia gas.

Compared with the formation of a silicon nitride film using a gas material including silane gas and ammonia gas and also compared with the formation of a silicon nitride film using silane gas and nitrogen gas (and optionally a rare gas), the film deposition rate in forming a silicon nitride film can be considerably improved to enable water vapor barrier films and semiconductor devices to be produced with high productivity and high efficiency.

### BRIEF DESCRIPTION OF THE DRAWINGS

FIG. 1 is a chart showing the relation between the amount of nitrogen gas introduced and the plasma emission in forming a silicon nitride film using silane gas and ammonia gas;
FIG. 2 is an enlarged view of FIG. 1 at wavelengths of around 336 to 340 nm;
FIG. 3 is an enlarged view of FIG. 1 at wavelengths of around 488 nm;
FIG. 4 is a graph showing the relation between the amount of nitrogen gas supplied and the film deposition rate in Examples of the invention; and
FIG. 5 is a graph showing the relation between the amount of nitrogen gas introduced and the film deposition rate in Examples of the invention provided that the film deposition rate at the nitrogen gas flow rate of 0 sccm is taken as 100%.

### DETAILED DESCRIPTION OF THE PREFERRED EMBODIMENTS

On the pages that follow, the silicon nitride film-forming method of the present invention is described in detail with reference to the accompanying drawings.

According to the silicon nitride film-forming method of the invention, a silicon nitride film is formed (deposited) through ICP-CVD by using a gas material including not only silane gas and ammonia gas but also nitrogen gas in such a manner that the flow rate (supply flow rate) of the nitrogen gas is 1 to 5 times the total flow rate (total quantity of flow) of the silane gas and the ammonia gas.

As described above, silicon nitride films are employed as water vapor barrier films in various devices and optical elements requiring moisture resistance, and protective films (passivation films) and insulating films in semiconductor devices.

With a view to producing water vapor barrier films or other films on a large scale with high productivity, a production method is implemented which involves continuously letting out an elongated substrate from a roll into which the substrate is wound, continuously forming a film on the elongated substrate traveling in a longitudinal direction and taking up the substrate having the film formed thereon. In order to improve the productivity and production efficiency in such a production method, it is necessary to improve the travel speed of the substrate through efficient film deposition, in other words, a very high film deposition rate is required.

Accordingly, the inventor of the invention has made intensive studies on the method of improving the film deposition rate in forming a silicon nitride film.

As a result, it has been found that the film deposition rate can be considerably improved by using not only silane gas and ammonia gas which are used for the gas material of the silicon nitride film but also nitrogen gas in such an amount that the flow rate of the nitrogen gas is 1 to 5 times the total flow rate of the silane gas and the ammonia gas and forming a silicon nitride film through ICP-CVD. The present invention has been thus completed.

A method as described in JP 2005-79254 A in which a gas material including silane gas and nitrogen gas is used to form a film on a substrate through ICP-CVD is known as a silicon nitride film-forming method.

However, the method using nitrogen gas as the gas material cannot achieve formation of a silicon nitride film at a high film deposition rate, because the activity of nitrogen is very low as is well known.

In this regard, JP 2005-79254 A describes that the film deposition rate can be improved by adding a rare gas in the process of forming a silicon nitride film through ICP-CVD using silane gas and nitrogen gas. Usually, an inert gas is very often added in film formation through ICP-CVD in order to stabilize discharge (maintain a high plasma density) and improve film thickness distribution, but in an application requiring a high film deposition rate, it is still difficult to ensure a high enough film deposition rate by adding a rare gas in formation of a silicon nitride film through ICP-CVD using a gas material including silane gas and nitrogen gas.

On the other hand, a silicon nitride film-forming method in which a gas material including silane gas and ammonia gas is used to form a film on a substrate through ICP-CVD is also known as described in JP 2005-79254 A.

This method can achieve film deposition at a high film deposition rate compared with the formation of a silicon nitride film using a gas material including silane gas and nitrogen gas, because the ammonia gas used in the method is much higher in activity than the nitrogen gas.

In the above-described ICP-CVD method in which silane gas and ammonia gas are used to form a silicon nitride film at such a high film deposition rate, the present invention additionally supplies nitrogen gas in such an amount that the flow rate of the nitrogen gas is 1 to 5 times the total flow rate of the silane gas and the ammonia gas to thereby achieve formation of a silicon nitride film at a higher film deposition rate.

As already described above and also described in JP 2005-79254 A, nitrogen gas is used as the gas material that serves as a nitrogen source in forming a silicon nitride film through ICP-CVD using silane as a silicon source. As is also well known, the activity of nitrogen gas is much lower than that of ammonia gas.

Therefore, according to a general way of thinking, nitrogen gas introduced in a silicon nitride film-forming system which uses a gas material including silane gas and ammonia gas is involved in the reaction, that is, film deposition. As a result, film formation with the less active nitrogen gas impedes film formation with the highly active ammonia gas. In addition, the less active nitrogen gas consequently dilutes the highly active ammonia gas, leading to reduction of the film deposition rate, although the nitrogen gas contributes to film deposition.

However, the inventor of the present invention has made an intensive study and as a result found that introduction of nitrogen gas in the process of forming a silicon nitride film using a gas material including silane gas and ammonia gas increases the amount of NH radicals which are active species contributing to the formation of the silicon nitride film, thus improving the film deposition rate. The present invention has been thus completed.

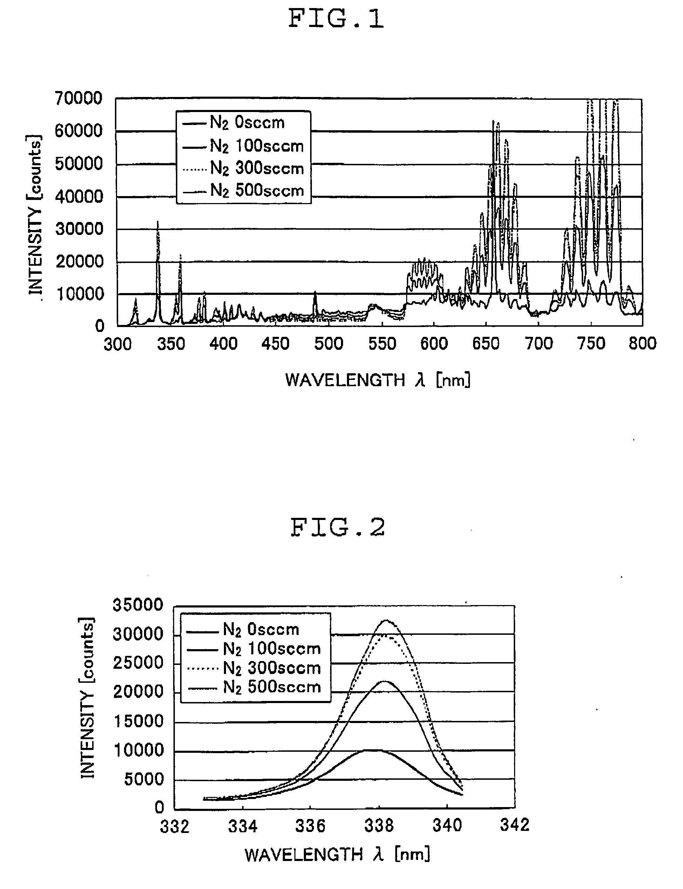

FIG. 1 shows variations in plasma emission intensity spectrum per unit time of 0.02 s in forming silicon nitride films through ICP-CVD using for the gas material silane gas and ammonia gas at flow rates of 50 sccm and 150 sccm, respectively, and also nitrogen gas at varying flow rates of 0 sccm, 100 sccm, 300 sccm, and 500 sccm.

The other conditions for film deposition are as described in Examples to be referred to later in the specification.

As shown in FIG. 1, introduction of nitrogen gas in the process of forming a silicon nitride film through ICP-CVD using a gas material including silane gas and ammonia gas changes the state of plasma emission, that is, amounts of existing radicals and ions, and their ratios. The plasma emission also varies with the amount of nitrogen gas introduced.

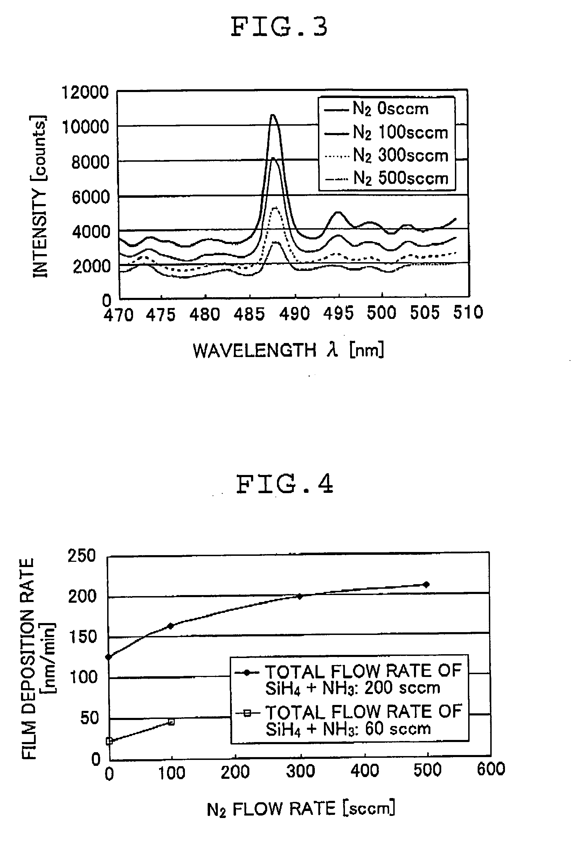

Plasma emission of NH radicals contributing to the deposition of a silicon nitride film is observed at wavelengths of around 336 to 340 nm. FIG. 2 is an enlarged view of FIG. 1 at wavelengths of around 336 to 340 nm. FIG. 3 is an enlarged view of FIG. 1 at wavelengths of around 488 nm where plasma emission of H radicals is observed.

As is seen from FIG. 2, introduction of nitrogen gas allows the plasma emission intensity of NH radicals to increase, that is, an increased amount of NH radicals are produced.

Both of N radical emission and NH radical emission are observed at wavelengths of around 336 to 340 nm. However, at wavelengths of around 488 nm in FIG. 3 where H radical emission is observed, the larger the amount of nitrogen gas introduced is, the lower the H radical emission intensity is. In other words, the amount of H radicals decreases. The intensity variations at wavelengths of around 336 to 340 nm due to introduction of nitrogen gas show that introduction of nitrogen gas did not simply increase the amount of N radicals but caused an increased amount of NH radicals to be produced, thus increasing the emission intensity. In other words, it can be confirmed that an increased amount of NH radicals are produced by the introduction of nitrogen gas in the process of forming a silicon nitride film through ICP-CVD using silane gas and ammonia gas. In addition, the larger the amount of nitrogen gas is, the more the amount of NH radicals produced is increased. The increase of the amount of NH radicals enables the film deposition rate to be improved in forming a silicon nitride film.

In addition, definite detection from the measurement of the plasma emission intensity spectrum is not possible, but it can be adequately presumed from the variations in the plasma emission intensity spectrum that the amount of NH-type radicals other than NH radicals such as NH₂ radicals that contribute to forming a silicon nitride film also varies. The film deposition rate in forming a silicon nitride film is improved presumably because of the increase of the amount of NH radicals and overall action of the introduced nitrogen gas on the NH-type radicals.

In other words, the film deposition rate can be improved to an unexpectedly high level as is shown in Examples to be referred to below, by making use of ICP-CVD in forming a silicon nitride film and by introducing a gas material including not only silane gas and ammonia gas but also nitrogen that is essentially deemed to impede film deposition.

As described above, in the silicon nitride film-forming method of the invention, the nitrogen gas (N₂) is used at the flow rate 1 to 5 times the total flow rate of the silane gas (SiH₄) and the ammonia gas (NH₃).

At a nitrogen gas flow rate of less than 0.2 times the total flow rate of the silane gas and the ammonia gas, the amount of the nitrogen gas is too small to fully improve the film deposition rate.

On the other hand, at a nitrogen gas flow fate of more than 20 times the total flow rate of the silane gas and the ammonia gas, the pressure is excessively increased to impair the uniformity in film thickness distribution. If the pressure is kept constant, the ratio of silane gas and ammonia gas which are not involved in the reaction and are therefore discharged is too increased to achieve the effects of the invention including an improved film deposition rate.

According to the invention, the flow rate of the nitrogen gas is 1 to 5 times the total flow rate of the silane gas and the ammonia gas.

By setting the flow rate of the nitrogen gas to not less than the total flow rate of the silane gas and the ammonia gas, the film deposition rate can be advantageously improved in a consistent manner owing to the introduction of the nitrogen gas. In addition, by setting the flow rate of the nitrogen gas to up to 5 times the total flow rate of the silane gas and the ammonia gas, more preferable results are obtained in terms of, for example, uniformity in film thickness distribution.

In the method of the invention to form a silicon nitride film, the total flow rate of the silane gas and the ammonia gas is not particularly limited but may be appropriately determined according to the required film deposition rate and film thickness.

According to the study made by the inventor of the invention, the total flow rate of the silane gas and the ammonia gas is preferably from 1 to 10,000 sccm and more preferably from 100 to 5,000 sccm.

By adjusting the total flow rate of the silane gas and the ammonia gas within the above-defined range, preferable results are obtained in terms of, for example, productivity and discharge stability.

The ratio of the flow rate of the ammonia gas to that of the silane gas is also not limited to any particular value, but may be appropriately set according to the composition (compositional ratio) of the silicon nitride film to be formed.

According to the study made by the inventor of the invention, the ammonia gas and the silane gas are preferably used at a flow rate ratio of the ammonia gas to the silane gas of from 1/1 to 10/1 and more preferably from 2/1 to 6/1.

By setting the flow rate ratio between the ammonia gas and the silane gas to not less than 1 (not less than 1/1), the ammonia gas can furnish a suitable amount of nitrogen to produce silicon nitride. At a flow rate ratio of not less than 2/1, a sufficient amount of nitrogen can be obtained more consistently. On the other hand, at a flow rate ratio between the ammonia gas and the silane gas of not more than 10 (not more than 10/1), the amount of the nitrogen gas with respect to that of the ammonia gas can be properly adjusted to consistently achieve the effect of improving the film deposition rate. At a flow rate ratio of particularly not more than 6/1, the amount of the nitrogen gas with respect to that of the ammonia gas can be properly adjusted to more advantageously achieve the effect of improving the film deposition rate.

Therefore, by adjusting the flow rate ratio between the ammonia gas and the silane gas within the above-defined range, the effect of the invention that the film deposition rate is improved in forming a silicon nitride film through ICP-CVD can be more advantageously achieved, and preferable results are also obtained in terms of the composition of the silicon nitride film formed.

In the method of the invention to form a silicon nitride film, the radio frequency power to be supplied for film deposition (hereinafter abbreviated as "RF power" which refers to electromagnetic wave energy applied to the film deposition system (film deposition chamber) is also not limited to any particular value but may be appropriately determined according to the required film deposition rate and film thickness.

According to the study made by the inventor of the invention, the RF power supplied for film deposition is preferably from 0.5 to 30 W/sccm and more preferably from 1 to 10 W/sccm with respect to the total flow rate of the gas material.

By adjusting the RF power within the above-defined range, preferable results are obtained in terms of, for example, discharge stability and reduced damage to the substrate.

In the method of forming a silicon nitride film according to the invention, the film deposition pressure is also not limited to any particular value but may be appropriately determined according to the required film deposition rate and film thickness as well as the flow rate of the gas material.

According to the study made by the inventor of the invention, the film deposition pressure is preferably in a range of from 0.5 to 20 Pa.

By adjusting the film deposition pressure within the above-defined range, the effect of the invention that the film deposition rate is improved in forming a silicon nitride film through ICP-CVD can be more advantageously achieved. What is more, preferable results are also obtained in terms of, for example, discharge stability and reduced damage to the substrate.

In the method of forming a silicon nitride film according to the present invention, the film deposition rate is also not limited to any particular value but may be determined as appropriate for the required productivity or other factors. According to the forming method of the present invention, the effect of improving the film deposition rate is achieved at any order of film deposition rate.

According to the study made by the inventor of the invention, the effect of improving the film deposition rate can be more advantageously achieved in a range of preferably from 1 to 3,000 nm/min and more preferably from 10 to 1,000 nm/min.

A silicon nitride film is formed by the silicon nitride film-forming method of the invention preferably at a low temperature and more preferably at a substrate temperature of as low as 0°C to 150°C.

As described above, according to the present invention, a silicon nitride film can be formed at a very high film deposition rate.

Accordingly, deposition of a silicon nitride film can be completed before the substrate has an elevated temperature. For example, in an apparatus in which film deposition is continuously carried out as the above-described elongated substrate is transported in the longitudinal direction, a film can be produced with high efficiency and high productivity as the substrate is transported at a high speed. In other words, according to the present invention, the effect of the invention that a silicon nitride film can be formed at a very high film deposition rate through film formation at a substrate temperature ranging from 0 to 150°C can be more advantageously achieved to thereby produce, with high productivity, a water vapor barrier film (moisture barrier film) on a less heat resistant substrate such as a polymer film that has been unattainable in the conventional silicon nitride film-forming methods.

What is more, the nitride film-forming method of the present invention that is carried out in the above-defined substrate temperature range enables considerable reduction of costs for the substrate cooling function provided in the ICP-CVD film deposition apparatus.

According to the silicon nitride film-forming method of the present invention, there is no particular limitation on the substrate (film deposition substrate) on which a silicon nitride film is to be formed, and any substrate on which a silicon nitride film can be formed is available.

Considering that the effect of the invention can be advantageously achieved owing to the high film deposition rate, that is, silicon nitride films can be formed with high productivity even at a low film deposition temperature, a silicon nitride film is preferably formed on a substrate having an organic layer (organic substance layer) such as a polymer layer (resin layer) formed thereon, more preferably on a substrate having an organic layer on which the film is to be deposited, and even more preferably on a substrate made of a polymer film (resin film).

A silicon nitride film may be formed (film deposition may be carried out) by implementing the silicon nitride film-forming method of the invention basically in the same manner as in a conventional ICP-CVD process except that the gas material including silane gas, ammonia gas and nitrogen gas is used and the flow rate of the nitrogen gas is adjusted in the above-defined predetermined range.

Therefore, the present invention avoids the necessity of using a special film deposition device and may be carried out by using a common ICP-CVD film deposition device in which RF power is supplied to an (induction) coil to form an induced magnetic field and therefore an induced electric field, and the gas material is introduced in the area of the induced electric field to generate plasma, thus forming a film on the substrate. Any known CVD devices (film deposition devices) to which an ICP-CVD process is applied are all available. However, as described above, film deposition is preferably carried out at a substrate temperature of as low as 0°C to 150°C and therefore a film deposition device having a function of substrate cooling is preferably used.

### EXAMPLES

The present invention is described below in further detail with reference to specific examples of the invention.

### Example 1

A common CVD device based on an ICP-CVD process was used to form a silicon nitride film on a substrate.

The substrate used was a polyester film with a thickness of 188 µm (polyethylene terephthalate film "Luminice" manufactured by Toray Advanced Film Co., Ltd.).

The substrate was set at a predetermined position within a vacuum chamber, and the vacuum chamber was closed.

Then, the vacuum chamber was evacuated to reduce the internal pressure. When the internal pressure had reached 7 × 10⁻⁴ Pa, silane gas, ammonia gas and nitrogen gas were introduced into the vacuum chamber. The silane gas and the ammonia gas were introduced at flow rates of 50 sccm and 150 sccm, respectively (total flow rate: 200 sccm).

Evacuation of the vacuum chamber was adjusted so that the vacuum chamber had an internal pressure of 3 Pa.

Then, 2 kW RF power was supplied to an induction coil and a silicon nitride film was formed on the surface of the substrate by ICP-CVD. During the film formation, the substrate temperature was controlled with a temperature adjusting means disposed at a substrate holder so that the substrate had a temperature of 70°C.

Silicon nitride films were formed at different nitrogen gas flow rates of 0 sccm, 100 sccm (the flow rate of the nitrogen gas being half the total flow rate of the silane gas and the ammonia gas), 300 sccm (1.5 times), and 500 sccm (2.5 times), and the film deposition rate was determined for the respective nitrogen gas flow rates.

The results are shown in FIG. 4.

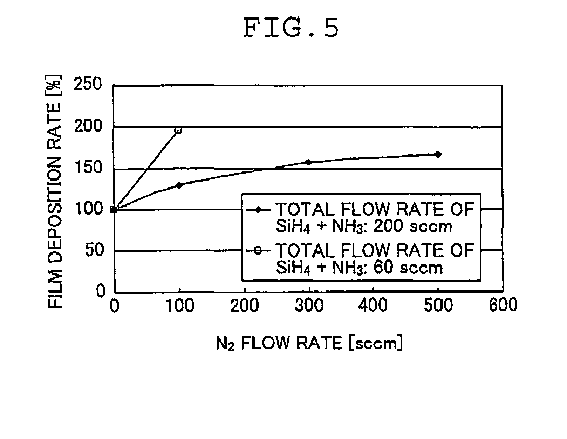

FIG. 5 shows the film deposition rate [%] in each nitrogen gas flow rate with respect to the nitrogen gas flow rate of 0 sccm taken as 100%.

### Example 2

Example 1 was repeated except that the silane gas and the ammonia gas were introduced at flow rates of 15 sccm and 45 sccm, respectively (at a total flow rate of 60 sccm) to thereby determine the relation between the nitrogen gas flow rate and the film deposition rate.

It should be noted that the nitrogen gas was introduced at flow rates of 0 sccm and 100 sccm (the nitrogen gas flow rate being about 1.67 times the total flow rate of the silane gas and the ammonia gas), respectively.

The flow rate is shown in FIG. 4 and the film deposition rate at a nitrogen gas flow rate of 100 sccm with respect to the nitrogen gas flow rate of 0 sccm taken as 100% is shown in FIG. 5.

As is seen from FIGS. 4 and 5, by forming a silicon nitride film through ICP-CVD using the gas material including the silane gas, ammonia gas and nitrogen gas, the film deposition rate can be considerably improved compared with cases where no nitrogen gas is used.

In the case where the total flow rate of the silane gas and ammonia gas is 200 sccm, for example, the film deposition rate can be considerably improved to about 1.25 times by adding the nitrogen gas in an amount half the total flow rate of the silane gas and ammonia gas. The film deposition rate can be improved to about 1.5 times or more by adding the nitrogen gas in an amount equal to or larger than the total flow rate of the silane gas and ammonia gas.

In the case where the total flow rate of the silane gas and ammonia gas is 60 sccm, the film deposition rate can be increased to about twice by adding the nitrogen gas in an amount about 1.67 times the total flow rate of the silane gas and ammonia gas.

The above results clearly show the beneficial effects of the present invention.

## Claims

1. A silicon nitride film-forming method comprising the steps of:
supplying a gas material including silane gas, ammonia gas and nitrogen gas in such a manner that the flow rate of the nitrogen gas is 1 to 5 times the total flow rate of the silane gas and the ammonia gas; and
carrying out inductively coupled plasma-enhanced chemical vapor deposition to form a silicon nitride film.

2. The silicon nitride film-forming method according to claim 1, wherein said silicon nitride film is formed at a substrate temperature of 0 to 150°C.

3. The silicon nitride film-forming method according to claim 1 or 2, wherein said silicon nitride film is formed on an organic material.

4. The silicon nitride film-forming method according to any one of claims 1 to 3, wherein said silicon nitride film is formed on a substrate having a base material made of a polymer film.

## Patentansprüche

1. Siliciumnitridfilm-bildendes Verfahren, umfassend die Schritte:
Zuführen eines Gasmaterials, das Silangas, Ammoniakgas und Stickstoffgas umfasst, auf solch eine Weise, dass die Flussrate des Stickstoffgases das 1- bis 5-fache der Gesamtflussrate des Silangases und des Ammoniakgases beträgt; und
Durchführen von induktiv gekoppelter Plasma-verstärkter chemischer Dampfphasenabscheidung, um einen Siliciumnitridfilm zu bilden.

2. Siliciumnitridfilm-bildendes Verfahren gemäß Anspruch 1, worin der Siliciumnitridfilm bei einer Substrattemperatur von 0 bis 150°C gebildet wird.

3. Siliciumnitridfilm-bildendes Verfahren gemäß Anspruch 1 oder 2, worin der Siliciumnitridfilm auf einem organischen Material gebildet wird.

4. Siliciumnitridfilm-bildendes Verfahren gemäß irgendeinem der Ansprüche 1 bis 3, worin der Siliciumnitridfilm auf einem Substrat gebildet wird, welches ein Basismaterial aufweist, das aus einem Polymerfilm gebildet ist.

## Revendications

1. Procédé de formation de film de nitrure de silicium comprenant les étapes consistant :
à alimenter un matériau gazeux comportant un gaz de silane, un gaz d'ammoniac et un gaz d'azote de telle manière que le débit du gaz d'azote soit 1 à 5 fois le débit total du gaz de silane et du gaz d'ammoniac ; et
à réaliser un dépôt chimique en phase vapeur activé par plasma inductif pour former un film de nitrure de silicium.

2. Procédé de formation de film de nitrure de silicium selon la revendication 1, dans lequel ledit film de nitrure de silicium est formé à une température de substrat allant de 0 à 150°C.

3. Procédé de formation de film de nitrure de silicium selon la revendication 1 ou 2, dans lequel ledit film de nitrure de silicium est formé sur un matériau organique.

4. Procédé de formation de film de nitrure de silicium selon l'une quelconque des revendications 1 à 3, dans lequel ledit film de nitrure de silicium est formé sur un substrat ayant un matériau de base réalisé en un film polymère.
